# FASCICULE DE BREVET EUROPEEN

(11) **EP 1 797 749 B1**
(45) Date de publication et mention de la délivrance du brevet: **19.01.2011**
(21) Numéro de dépôt: 05802899.4
(22) Date de dépôt: 29.09.2005
(51) Int. Cl.: H05K 3/34, H05K 13/04

(54) **COMPOSANT MUNI D'UN ENSEMBLE DE MICROPOINTES CONDUCTRICES DURES ET PROCEDE DE CONNEXION ELECTRIQUE ENTRE CE COMPOSANT ET UN COMPOSANT MUNI DE PROTUBERANCES CONDUCTRICES DUCTILES**
KOMPONENTE MIT EINER ANORDNUNG VON HARTEN LEITFÄHIGEN MIKROSPITZEN UND VERFAHREN ZUR ELEKTRISCHEN VERBINDUNG BESAGTER KOMPONENTE UND EINE MIT DEHNBAREN LEITFÄHIGEN ERHEBUNGEN BESTÜCKTE KOMPONENTE
COMPONENT PROVIDED WITH AN ASSEMBLY OF HARD CONDUCTIVE MICROTIPS AND METHOD FOR ELECTRICAL CONNECTION OF SAID COMPONENT AND A COMPONENT PROVIDED WITH DUCTILE CONDUCTIVE PROTRUSIONS

(30) Priorité: 04.10.2004 FR 0452252
(43) Date de publication de la demande: 20.06.2007
(73) Titulaire: Commissariat à l'Énergie Atomique et aux Énergies Alternatives, 75015 Paris (FR)
(72) Inventeur: DAVOINE, Cécile, F-76620 LE HAVRE (FR); MARION, François, F-38950 SAINT-MARTIN-DE-VINOUX (FR)
(74) Mandataire: Poulin, Gérard
(86) Numéro de dépôt international: PCT/FR2005/050793
(87) Numéro de publication internationale: WO 2006/037915

(56) Documents cités:
- US-A1- 2002 153 608
- US-A1- 2003 234 277

## Description

### DOMAINE TECHNIQUE

La présente invention concerne un composant muni d'un ensemble de pointes conductrices dures et un procédé de connexion électrique entre ce composant et un composant muni de protubérances conductrices ductiles.

### ÉTAT DE LA TECHNIQUE ANTÉRIEURE

Dans le domaine de la connectique utilisant la technique « flip chip », la tendance actuelle est à la réduction du « pas », c'est-à-dire de la distance entre les interconnexions reliant puce et substrat. Dans une telle technique un substrat a tous les contacts, sous forme de micro-billes ou de protubérances (« bump ») métalliques, situés sur une seule face. La puce est retournée de telle sorte que les protubérances puissent être soudées à des conducteurs appropriés sur cette puce. Cependant les méthodes d'hybridation conventionnelles telles que la brasure de micro-billes ou la thermo-compression de plots, ainsi que des méthodes plus récentes telles que les ACF (« Anisotropic Conductive Films ») ou l'utilisation de polymères conducteurs montrent leurs limites en termes de réduction du pas.

La réalisation de connexions électriques par insertion de micro-pointes ou « pointes » conductrices dures dans des micro-billes conductrices ductiles apparaît être une solution compatible avec une telle réduction du pas dans la mesure où elle est « sans-flux », nécessite une faible pression mécanique et permet de rattraper les flèches éventuelles de la puce ou du substrat.

Le document référencé [1] en fin de description décrit, ainsi, un procédé de connexion par insertion d'une première pièce munie de plusieurs pointes avec une seconde pièce munie de plots surmontés de micro-billes de soudure sans utiliser de flux. Ce procédé comprend les étapes consistant à aspirer sous vide la première pièce, presser au moins une pointe de la première pièce contre un plot de la seconde pièce, percer à l'aide de cette pointe la croûte d'oxyde natif en surface de la micro-bille de soudure en chauffant au dessus de la température de fusion du matériau constituant la micro-bille, refroidir, et solidifier la micro-bille de soudure fondue. La surface de la micro-bille de soudure est, en effet, revêtue par un film en oxyde comme un enrobage dur, de telle sorte que, même si la pointe est pressée fermement contre la micro-bille de soudure en chauffant au dessus de la température de fusion du matériau constituant la micro-bille, la soudure ne coule pas sur le côté, et il n'y a pas production d'un pont de soudure.

Le principal avantage d'un tel procédé de connexion électrique par insertion est de pouvoir se passer du flux, contrairement aux méthodes d'hybridation conventionnelles (brasure de micro-billes et thermo-compression) qui font appel à l'utilisation d'une solution d'attaque chimique, le flux, permettant d'éliminer la couche d'oxyde natif en surface de l'alliage. Dans ces méthodes l'étape de rinçage du flux est délicate à réaliser à faible pas. Des résidus de flux font, en effet, obstacle à la propagation de la colle d'enrobage servant à renforcer le couplage thermomécanique entre la puce et le substrat lors de leur utilisation à chaud ou à froid, ce qui entraîne la présence de bulles qui sont néfastes à un empilement d'un point de vue thermomécanique.

De plus, les méthodes d'hybridation conventionnelles telles que la brasure de micro-billes et la thermo-compression requièrent une élévation de température au-dessus de la température de fusion de l'alliage qui sert de connexion électrique, qui peut conduire à une détérioration des composants à hybrider. De plus, à cause du désaccord des coefficients de dilatation thermique de la puce et du substrat, il y a un décalage des plots sensés être en vis-à-vis. C'est pourquoi dans le cas d'une hybridation à très faible pas, ce décalage peut conduire à des connexions manquantes en périphérie de puce. Il est donc intéressant de travailler à basses températures.

Dans la mesure où le contact électrique est réalisé par insertion d'un matériau dans un autre et que le maintien mécanique est assuré par une colle d'enrobage, il n'est théoriquement pas nécessaire de monter en température. Cependant il est possible de chauffer modérément l'ensemble pendant l'hybridation, afin de ramollir la micro-bille. Cela peut se faire à température modérée, par exemple aux 2/3 de la température de fusion du matériau constituant la micro-bille. D'autre part, on peut envisager de chauffer après l'insertion afin d'assurer un bon contact électrique. Dans ce cas, il n'y a pas de problème de décalage de plots en vis-à-vis pendant l'hybridation.

En outre, plus la densité d'interconnexion est élevée, plus la pression à exercer lors du report de puce par thermo-compression, ACF ou utilisation de polymères conducteurs est importante, ce qui diminue la précision concernant l'alignement. Or c'est un point important dans le cas d'une forte densité de connexions. Par contre la forme des pointes permet d'appliquer des pressions raisonnables pour réaliser l'insertion; c'est-à-dire des pressions qui sont compatibles avec les machines de « flip chip » actuelles.

Enfin une connexion peut être réalisée avec différentes profondeurs d'insertion ce qui permet de s'affranchir des défauts de planéité du substrat ou de la puce ainsi que des irrégularités d'épaisseur des billes.

La réalisation d'une connexion par insertion d'une pointe dans une micro-bille nécessite cependant un niveau d'alignement supplémentaire par rapport aux méthodes de « flip chip » conventionnelles. En effet, il est nécessaire d'aligner précisément les plots, les billes et les pointes.

L'objet de l'invention est de pallier cet inconvénient en utilisant un ensemble de pointes qui permet de supprimer le niveau d'alignement des pointes au-dessus des plots.

### EXPOSÉ DE L'INVENTION

La présente invention concerne un procédé de connexion électrique entre un premier composant comportant, sur une face, un ensemble de premiers plots et un ensemble de pointes conductrices dures et un second composant comportant, sur une face, un ensemble de seconds plots et un ensemble de protubérances conductrices ductiles, dans lequel on met en vis-à-vis les deux faces et on les rapproche de telle façon que les pointes puissent pénétrer dans ces protubérances, **caractérisé en ce que** l'espace entre deux pointes est inférieur à la largeur d'une protubérance et à la largeur d'un premier plot.

Dans un mode de réalisation les protubérances sont obtenues par dépôt de matériau au fond de cavités au dessus de chaque second plot ou par gravure.

Dans un mode de réalisation les pointes sont obtenues par dépôt métallique, croissance électrolytique, nanoimpression métallique, gravure, ou croissance de nanotubes alignés.

L'invention concerne également un composant comportant, sur une face, un ensemble de premiers plots et un ensemble de pointes conductrices dures apte à être connecté électriquement avec un autre composant muni, sur une face, d'un ensemble de second plots et d'un ensemble de protubérances conductrices ductiles, **caractérisé en ce que** l'espace entre deux pointes est inférieur à la largeur d'une protubérance et à la largeur d'un premier plot.

Chaque protubérance est en matériau conducteur électrique comme par exemple une pâte à brasure ou une colle conductrice.

Chaque pointe peut être en métal, plus généralement en matériau conducteur. Chaque pointe peut aussi être un nanotube ou un nanofil.

### BRÈVE DESCRIPTION DES DESSINS

Les figures 1A et 1B illustrent la réalisation d'une connexion par insertion d'un ensemble de pointes dans des protubérances selon le procédé de l'invention.
La figure 2 illustre un procédé de l'art connu.
Les figures 3 et 4 illustrent plusieurs caractéristiques du procédé de l'invention.
Les figures 5A à 9C illustrent plusieurs modes de réalisation du procédé de l'invention.

### EXPOSÉ DÉTAILLÉ DE MODES DE RÉALISATION PARTICULIERS

Le procédé de l'invention est un procédé de connexion électrique de plots utilisant la technique « flip chip » sans flux.

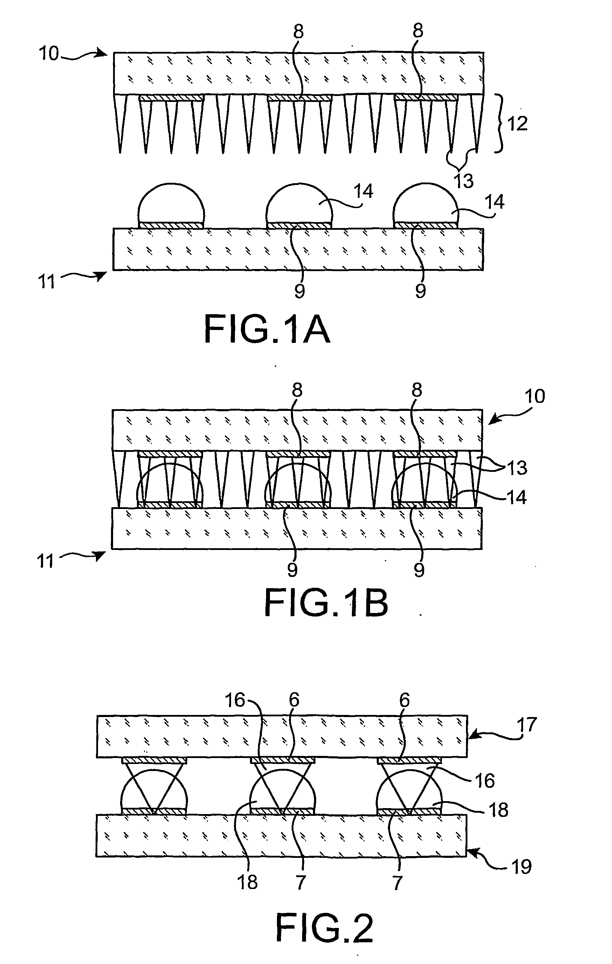

Dans le procédé de l'invention on réalise cette connexion entre les plots 8 d'un premier composant 10 et les plots 9 d'un second composant 11, par exemple un substrat, par insertion d'un « tapis », ou ensemble, 12 de pointes conductrices dures 13 disposé sur une face de ce premier composant 10 dans un ensemble de micro-billes ou protubérances conductrices ductiles 12 disposé sur une face du second composant, comme illustré sur les figures 1A et 1B.

Le concept de réalisation de connexions par insertion est connu. Il est décrit, par exemple, dans le document référencé [1]. Mais dans ce document, pour réaliser la connexion entre des plots 6 et 7 des deux composants 17 et 19, chaque micro-pointe 16 du premier composant 17 correspond à une bille 18 du second composant 19 qu'elle peut venir percer, comme illustré sur la figure 2.

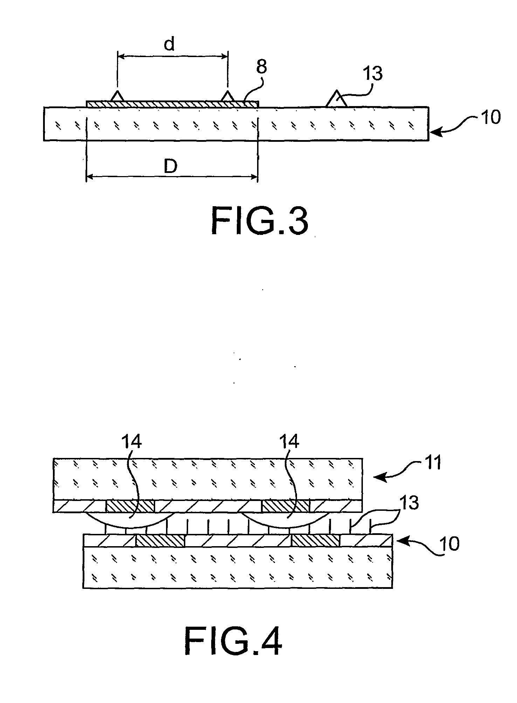

L'avantage de l'invention qui réalise ainsi les pointes en « tapis » est double. D'une part, on se passe d'un niveau d'alignement pendant leur fabrication. En effet, il n'est pas nécessaire d'aligner les pointes 13 sur les plots 8 comme dans le cas des pointes unitaires de l'art antérieur illustré sur la figure 2. Il suffit de réaliser le « tapis » de pointes 13 de façon à ce que la distance d entre deux pointes 13 soit inférieure à la largeur D d'un plot 8 de connexion comme illustré sur la figure 3. Ainsi on est sûr qu'il y a au moins une pointe 13 par plot 8. D'autre part, le fait d'avoir un « tapis » de pointes permet d'être moins précis sur l'alignement.

De plus, pour que le contact soit réalisé malgré le désalignement il suffit que la distance entre deux pointes 13 soit inférieure à la largeur d'une bille 14 comme illustré sur la figure 4. Ainsi on est sûr qu'il y a au moins une pointe qui vient s'insérer dans une micro-bille.

Une telle insertion peut être réalisée en jouant sur les modules d'Young des matériaux respectifs constituant les pointes 13 et les micro-billes 14, et/ou sur la forme de pointes 13. En effet, plus le rapport des modules d'Young entre les deux matériaux est élevé, plus l'insertion est facile. On peut donc choisir n'importe quel couple de matériaux conducteurs : par exemple une pointe en métal et une micro-bille en pâte à brasure (In, SnPb, AuSn...). De même, plus la pointe a une forme pointue, moins la pression à exercer est importante. Les pointes 13 doivent être suffisamment dures et fines, ayant par exemple :
- un angle au sommet inférieur à 30°,
- un rapport supérieur à 10 entre les modules d'young de la pointe et de la protubérance, pour pouvoir percer la croûte d'oxyde et s'enfoncer dans les micro-billes 14 avec une pression mécanique minimale.

### Réalisation des protubérances

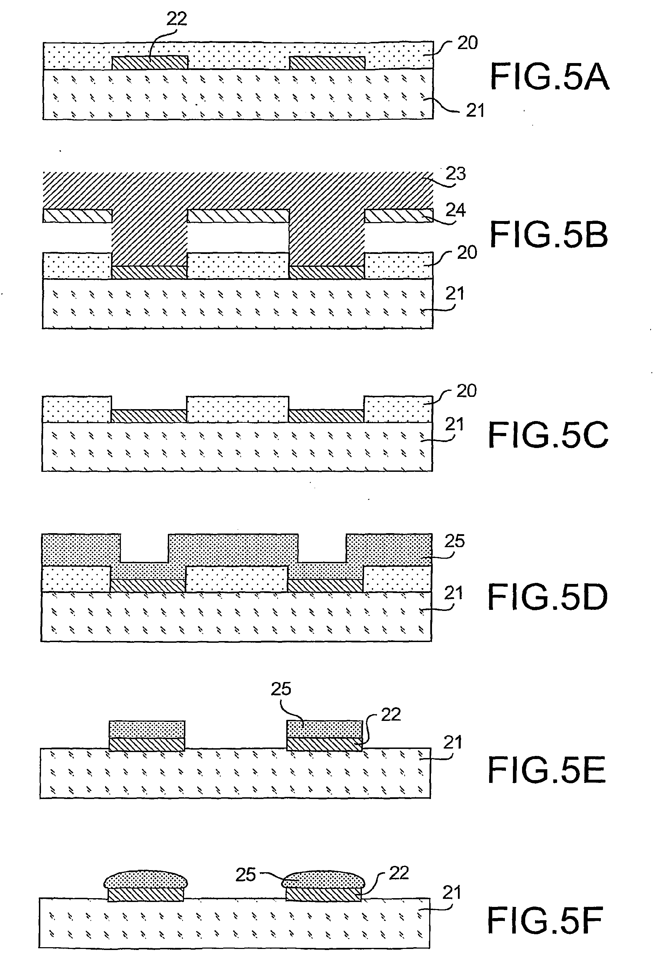

Les protubérances peuvent être obtenus classiquement par dépôt au fond de cavités en résine au-dessus de chaque contact électrique (procédé « lift-off » classique, ou soulèvement de résine). On a ainsi les étapes suivantes :
- une étape de dépôt de résine 20 pleine plaque sur un substrat 21 muni de plots 22 (figure 5A),
- une étape d'insolation au rayonnement ultra-violet 23 sous masque 24 (figure 5B),
- une étape de retrait de la résine insolée (figure 5C),
- une étape de dépôt du matériau 25 constituant les micro-billes (figure 5D),
- une étape de retrait de la résine (figure 5E) grâce à un révélateur de résine,
- de façon optionnelle une étape de refonte du matériau pour constituer une bille (figure 5F).

Les protubérances peuvent être aussi réalisées par un autre procédé classique : dépôt du matériau ductile sur toute la surface puis gravure à travers un masque.

### Réalisation des pointes

L'ensemble de pointes peut être obtenu de plusieurs manières, par exemple par dépôt par métallique, gravure, croissance électrolytique, procédé électrodéposition (« electroless »), nanoimpresion métallique ou croissance de nanotubes de carbone alignés...

### 1) Dépôt métallique

Une première technique consiste à réaliser un dépôt de métal par pulvérisation ou évaporation au-dessus de cavités de résine. Au fur et à mesure du dépôt l'ouverture s'obstrue et la quantité de métal déposé en fond de cavité diminue. Ainsi la forme obtenue en fond de cavité devient conique.

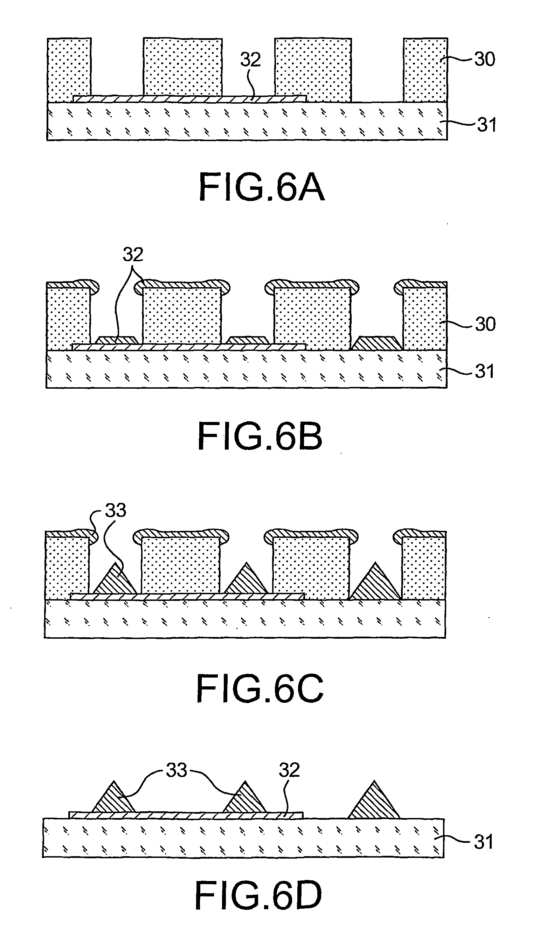

On a ainsi les étapes suivantes :
- une étape de dépôt d'un masque de résine 30 par photolithographie sur un substrat 31 muni de plots 32(figure 6A),
- une étape de dépôt d'un métal 33 (figures 6B et 6C),
- une étape de retrait de la résine (figure 6D).

Une deuxième technique consiste à réaliser le même dépôt mais sur toute la surface, à déposer un masque en résine puis à graver le métal par gravure chimique.

### 2) Croissance électrolytique

On peut également réaliser une croissance électrolytique d'un métal au fond d'une cavité de résine dont les flancs sont obliques. Cette oblicité peut-être obtenue par exemple grâce à un double résinage. On dépose alors deux types de résines qui n'ont pas la même sensibilité à l'insolation. Une fois insolées, elles ne se dissolvent pas de la même façon.

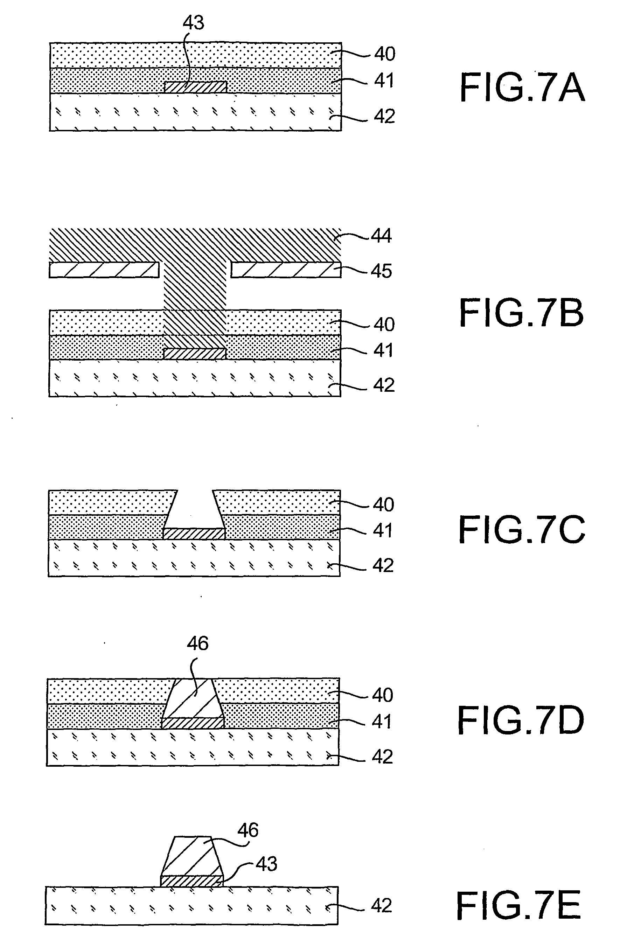

On a ainsi les étapes suivantes :
- une étape de double résinage par dépôt de deux résines 40 et 41 sur un substrat 42 muni de plots 43 (figure 7A),
- une étape d'insolation au rayonnement ultrat-violet 44 sous masque 45 (figure 7B),
- une étape de dilution des résines insolées (figure 7C),
- une étape de dépôt électrolytique du matériau 46 constituant les pointes (figure 7D),
- une étape de retrait des deux résines 40 et 41 (figure 7E).

### 3) Nanoimpression métallique

A l'origine, la technique de nanoimpression est utilisée pour mouler des polymères, mais il est également envisageable de mouler des alliages à condition de les chauffer aux alentours de la température de fusion. Il faut choisir des alliages à bas point de fusion.

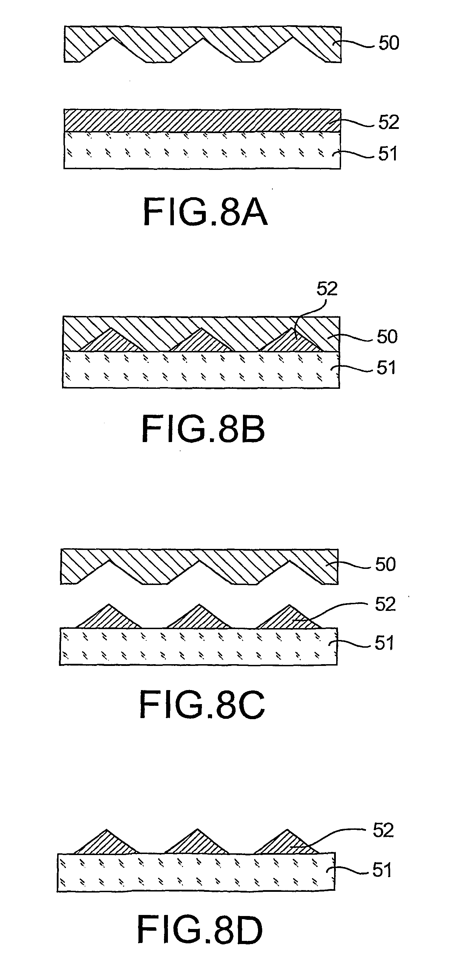

On a ainsi les étapes suivantes :
- une étape d'emboutissage d'un moule 50 sur un substrat 51 sur lequel est déposée classiquement une couche d'alliage 52, (figures 8A et 8B),
- une étape de retrait du moule (figures 8C et 8D).

Les motifs du moule peuvent être réalisés de plusieurs manières : on peut utiliser un moule, en silicium par exemple, et réaliser les trous pyramidaux par attaque chimique anisotrope (KOH) suivant des plans cristallins. On peut également réaliser le moule par emboutissage à chaud. Le matériau doit être suffisamment résistant thermiquement et mécaniquement pour ne pas cliver sous l'application d'une force.

### 4) Croissance de pointes en nanotubes de carbones.

On peut faire croître des nanotubes (ou des nanofils) sous champ électrique afin de les orienter. Cette technique est décrite dans le document référencé [2]. Ce document envisage, en effet, la croissance directe de réseaux de nanotubes de carbone alignés verticalement sur des substrats en plastique flexible en utilisant un dépôt en vapeur chimique.

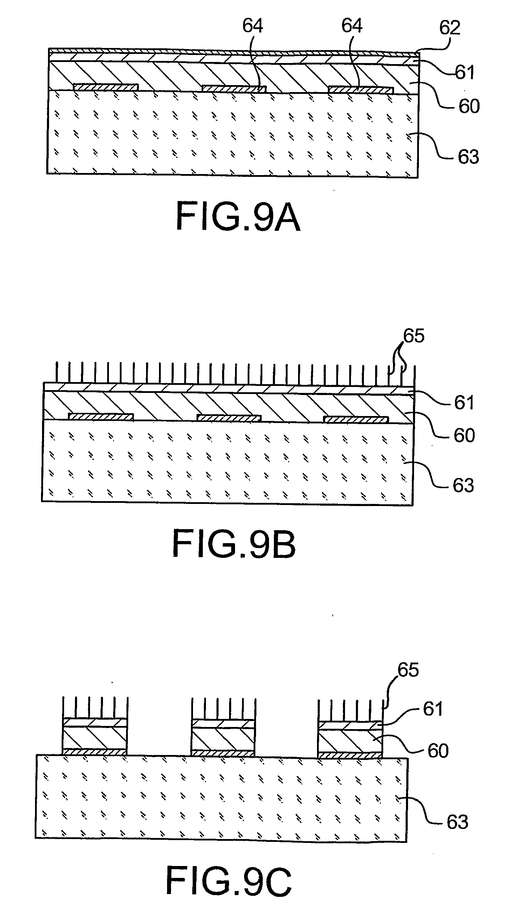

On a alors les étapes suivantes :
- une étape de dépôt de TiN 60, de dépôt de Ni 61 et de dépôt de catalyseur 62 sur un substrat 63 muni de plots 64 (figure 9A),
- une étape de mise en goutte du catalyseur et de croissance des nanotubes 65 à 450°C(figure 9B).

De façon avantageuse, ces nanotubes peuvent croître localement grâce à un procédé de masquage lors du dépôt des différentes couches nécessaires à leur élaboration (figure 9C).

### REFERENCES

[1] US 6,179 198
[2] Article intitulé « Direct Growth of aligned carbon nanotube field emitter arrays onto plastic substrates » de S. Hofman, C. Ducati, B. Kleinsorge, et J. Robertson (Applied Physics Letters, Volume 83, Numéro 22, 1er décembre 2003)

## Revendications

1. Procédé de connexion électrique entre les premiers plots d'un premier composant et les seconds plots d'un second composant, le premier composant (10) comportant, sur une face, un ensemble des premiers plots (8) et un tapis de pointes conductrices dures (13) et le second composant (11) comportant, sur une face, un ensemble des seconds plots (9) et un ensemble de protubérances conductrices ductiles (14), dans lequel on met en vis-à-vis les deux faces et on les rapproche de telle façon qu'au moins une pointe (13) vient pénétrer dans chaque protubérance (14), **caractérisé en ce que** l'espace entre deux pointes (13) est inférieur à la largeur d'une protubérance (14) et à la largeur d'un premier plot (8).

2. Procédé selon la revendication 1, dans lequel les protubérances sont obtenues par dépôt de matériau au fond de cavités au dessus de chaque second plot (9), ou par gravure.

3. Procédé selon la revendication 1, dans lequel les pointes sont obtenues par dépôt métallique, gravure, croissance électrolytique, nanoimpression métallique, ou croissance de nanotubes alignés.

4. Composant comportant, sur une face, un ensemble de premiers plots (8) et un tapis de pointes conductrices dures (13) apte à être connecté électriquement avec un autre composant muni, sur une face, d'un ensemble de second plots (9) et d'un ensemble de protubérances conductrices ductiles (14), **caractérisé en ce que** l'espace entre deux pointes (13) est inférieur à la largeur d'une protubérance (14) et à la largeur d'un premier plot (8).

5. Composant selon la revendication 4, dans lequel chaque pointe est constituée toute ou en partie par un matériau conducteur électrique.

6. Composant selon la revendication 4, dans lequel chaque pointe est un nanotube ou un nanofil.

7. Composant selon la revendication 4, dans lequel chaque protubérance est constituée par au moins un matériau conducteur électrique.

8. Composant selon la revendication 7, dans lequel le matériau de la protubérance est choisi parmi une pâte à brasure et une colle conductrice.

## Claims

1. Process for making an electrical connection between the first pads of a first component and the second pads of a second component, the first component (10) comprising a set of the first pads (8) and a mat of hard conducting tips (13) on one face, and the second component (11) comprising a set of the second pads (9) and a set of ductile conducting bumps (14) on one face, in which the two faces are made to face each other and they are brought towards each other such that at least one tip (13) penetrates into each bump, **characterized in that** the space between two tips (13) is less than the width of a bump (14) and less than the width of a first pad (8).

2. Process set forth in claim 1, in which the bumps are obtained by deposition of material at the bottom of the cavities above each second pad (9), or by etching.

3. Process set forth in claim 1, in which the tips are obtained by metallic deposition, electrolytic growth, metallic nanoprinting, etching or growth of aligned nanotubes.

4. Component comprising a set of first pads (8) and a mat of hard conducting tips (13) on one face, that can be electrically connected with another component provided with a set of second pads (9) and a set of ductile conducting bumps (14) on one face, **characterized in that** the space between two tips (13) is less than the width of a bump (14) and less than the width of a first pad (8).

5. Component set forth in claim 4, in which each tip is made wholly or partly from an electrical conducting material.

6. Component set forth in claim 4, in which each tip is a nanotube or a nanowire.

7. Component set forth in claim 4, in which each bump is made of at least one electrical conducting material.

8. Component set forth in claim 7, in which the material from which the bump is made is chosen from among a brazing paste or a conducting glue.

## Patentansprüche

1. Verfahren zur elektrischen Verbindung zwischen ersten Kontaktelementen eines ersten Bauteils und zweiten Kontaktelementen eines zweiten Bauteils, wobei das erste Bauteil (10) auf einer Seite eine Gruppe erster Kontaktelemente (8) und einen Teppich aus harten leitfähigen Spitzen (13) umfasst, und das zweite Bauteil (11) auf einer Seite eine Gruppe zweiter Kontaktelemente (9) und eine Gruppe duktiler Höcker (14) umfasst, bei dem man die beiden Seiten in Gegenüberstellung bringt und einander so nähert, dass in jeden Höcker (14) wenigstens eine Spitze (13) eindringt,
**dadurch gekennzeichnet, dass** der Abstand zwischen zwei Spitzen (13) kleiner ist als die Breite eines Höckers (14) und als die Breite eines ersten Kontaktelements (8).

2. Verfahren nach Anspruch 1, bei dem die Höcker realisiert werden durch Abscheiden von Material auf dem Boden von Hohlräumen über jedem zweiten Kontaktelement (9), oder durch Ätzen.

3. Verfahren nach Anspruch 1, bei dem die Spitzen realisiert werden durch metallische Abscheidung, Ätzung, elektrolytisches Wachstum, metallischen Nanodruck oder Wachstum von ausgerichteten Nanoröhrchen.

4. Bauteil mit - auf einer Seite - einer Gruppe erster Kontaktelemente (8) und einem Teppich aus harten leitfähigen Spitzen (13), das elektrisch mit einem anderen Bauteil verbunden werden kann, das auf einer Seite eine Gruppe zweiter Kontaktelemente (9) und eine Gruppe duktiler leitfähiger Höcker (14) umfasst, **dadurch gekennzeichnet, dass** der Abstand zwischen zwei Spitzen (13) kleiner ist als die Breite eines Höckers (14) und als die Breite eines ersten Kontaktelements (8).

5. Bauteil nach Anspruch 4, bei dem jede Spitze ganz oder teilweise durch ein Material aus einem elektrisch leitfähigen Material ist.

6. Bauteil nach Anspruch 4, bei dem jede Spitze ein Nanoröhrchen oder eine Nanofaser ist.

7. Bauteil nach Anspruch 4, bei dem jeder Höcker aus wenigstens einem elektrisch leitfähigen Material gebildet ist.

8. Bauteil nach Anspruch 7, bei dem das Material des Höckers ausgewählt wird unter einer Lötpaste und einem leitfähigen Klebstoff.
